# FASCICULE DE BREVET EUROPEEN

(11) **EP 2 743 835 B1**
(45) Date de publication et mention de la délivrance du brevet: **02.09.2015**
(21) Numéro de dépôt: 13197817.3
(22) Date de dépôt: 17.12.2013
(51) Int. Cl.: H03K 19/00, G06F 13/40

(54) **Circuit d'échange de données bidirectionnel**
Bidirektionaler Datenaustauschschaltkreis
Circuit for bi-directional data exchange

(30) Priorité: 17.12.2012 FR 1203440
(43) Date de publication de la demande: 18.06.2014
(73) Titulaire: Thales, 92200 Neuilly Sur Seine (FR)
(72) Inventeur: Pubert, Laurent, 49309 CHOLET (FR); Pichet, Jérôme, 49309 CHOLET (FR); Grimonprez, Benjamin, 49309 CHOLET (FR); Collange, Thierry, 49309 CHOLET (FR)
(74) Mandataire: Blot, Philippe Robert Emile

(56) Documents cités:
- EP-A1- 0 044 397
- JP-A- H04 199 351
- US-A- 5 418 933
- US-A- 5 877 633
- US-A1- 2014 184 269

## Description

La présente invention concerne un circuit d'échange de données bidirectionnel comportant :
- un buffer comportant :
   - un premier ensemble de bornes et un second ensemble de bornes dont les bornes sont appariées deux à deux pour un échange de données bidirectionnel entre deux bornes appariées des deux ensembles ;
   - une entrée de sens de transfert entre deux bornes appariées d'une entrée vers une sortie, l'entrée étant placée en haute impédance en l'absence de tension à ces bornes ;
   - une entrée de commande du sens de transfert.

Le document US 5 418 933 A décrit un circuit d'échange de données bidirectionnel, du type précité.

Dans certaines cartes électroniques numériques disposant d'automates de sécurité, par exemple dans des circuits de signalisation ferroviaire, il est nécessaire de permettre l'écriture initiale de données dans une mémoire au travers d'un buffer ou mémoire tampon, puis ultérieurement d'interdire toute nouvelle écriture, tout en permettant, au travers du buffer, l'accès en lecture seule des données contenues dans la mémoire.

Le buffer est alors intégré dans un circuit d'échange permettant à un circuit programmable d'accéder initialement en écriture à une mémoire pour y inscrire des données puis de verrouiller définitivement ces données pour ne plus en permettre que la lecture dans la mémoire après cette première phase d'écriture.

Un buffer bidirectionnel comporte une borne de commande propre à recevoir un signal de sens permettant d'imposer dans le buffer la circulation des données dans un seul des deux sens possibles.

Pour permettre le verrouillage d'un buffer bidirectionnel, il est connu par exemple de piloter le signal de sens à l'aide d'un cavalier sur la carte électronique. Cette solution nécessite toutefois une opération manuelle fastidieuse.

Il est également connu de piloter le signal de sens par un composant programmable. Toutefois, cette solution présente des risques de bug, nuisant à la sûreté de fonctionnement. En effet, le pilotage du signal de sens du buffer directement par un composant programmable peut être compromis par une défaillance logicielle.

Une autre solution consiste à piloter le signal de sens à l'aide d'une bascule en profitant de l'effet mémoire de ce type de composant, rendant indépendant le pilotage du signal avec une éventuelle faille dans le logiciel du composant programmable.

L'utilisation de composants logiques spécifiques tels qu'une bascule nécessite de gérer en nomenclature un nouveau type de composants peu ou pas utilisé sur la carte, ce qui augmente le coût de la carte électronique.

L'invention a pour but de proposer un circuit d'échange de données bidirectionnel, dont le sens de transfert des données peut être fixé définitivement après un premier choix dans le sens de circulation des données, qui soit sûr et garantisse une sécurité des données transférées.

A cet effet, l'invention a pour objet un circuit d'échange de données bidirectionnel du type précité,
caractérisé en ce qu'il comporte une porte logique dont :
- la sortie est reliée à l'entrée de sens de transfert du buffer ;
- une entrée est reliée à l'entrée de commande du sens de transfert, cette entrée étant en outre reliée à un premier potentiel de référence par une résistance ; et
- l'autre entrée est reliée à une borne du buffer et au premier potentiel de référence par une résistance ;
- la borne du buffer appariée à la borne du buffer à laquelle est reliée l'autre entrée de la porte logique étant reliée à un second potentiel de référence par une résistance ;
et en ce que les première et seconde potentiels de référence et la nature de la porte logique sont tels que, après une première commande de sens de transfert du buffer dans un sens, les deux bornes appariées réservées pour le module de commande forcent la porte logique dans un état prédéterminé indépendant de la valeur du signal sur l'entrée de commande de sens.

Suivant des modes particuliers de réalisation, le circuit d'échange de données bidirectionnel comporte l'une ou plusieurs des caractéristiques suivantes prises suivant toutes les combinaisons techniquement possibles :
- la porte logique est une porte ET, et le second potentiel de référence est inférieur au premier potentiel de référence ;
- la porte logique est une porte OU et le second potentiel de référence est supérieur au premier potentiel de référence ;
- le buffer comporte une entrée pour un signal d'activation, interdisant tout transfert entre deux bornes appariées en l'absence de signal d'activation ; et
- le buffer comporte deux bornes auxiliaires appariées différentes des bornes appariées en relation avec l'entrée de commande de direction, dont :
   - la borne auxiliaire du même ensemble que la borne reliée à la porte logique est reliée :
      - d'une part, à une sortie de fourniture d'une information représentative du sens de transfert et,
      - d'autre part, par une résistance, à un des premier et second potentiels de référence, et
   - l'autre borne auxiliaire est reliée par une résistance à l'autre des premier et second potentiels de référence.

L'invention sera mieux comprise à la lecture de la description qui va suivre, donnée uniquement à titre d'exemple et faite en se référant aux dessins sur lesquels :
- la figure 1 est une vue schématique d'un premier mode de réalisation d'un circuit d'échange de données bidirectionnel selon l'invention bloquant, après une autorisation initiale le transfert des données dans un premier sens ;
- la figure 2 est une vue schématique de la structure du buffer utilisé dans le circuit d'échange de la figure 1 ; et
- la figure 3 est une vue identique à celle de la figure 1 d'un second mode de réalisation d'un circuit d'échange de données bidirectionnel bloquant, après une autorisation initiale, la circulation des données dans un second sens opposé au premier sens.

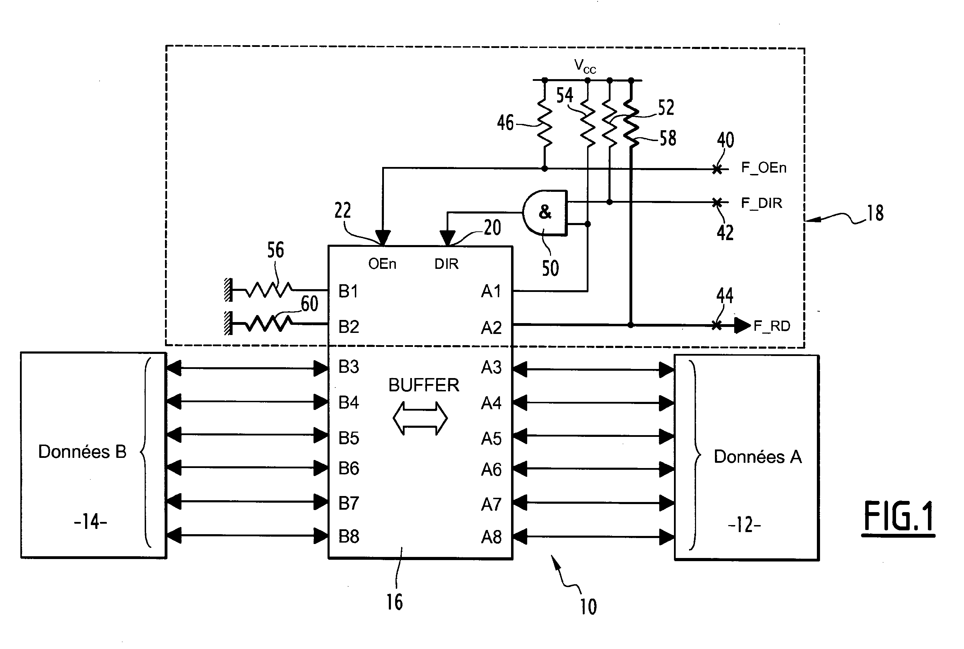

Le circuit d'échange 10 de données bidirectionnel illustré sur la figure 1 est mis en oeuvre par exemple entre un processeur 12 et une mémoire 14, et plus généralement, entre deux dispositifs électroniques devant échanger des données.

Le circuit d'échange 10 est propre à permettre, lors d'une phase initiale unique, le transfert des données du processeur 12 vers la mémoire 14 puis après ce transfert initial à n'autoriser pour le futur que le transfert des données de la mémoire 14 vers le processeur 12, sans que le processeur ne puisse à nouveau écrire dans la mémoire.

Le circuit 10 comporte un buffer ou mémoire tampon 16. Il comporte en outre un circuit 18 de commande du sens de transfert des données dans le buffer 16.

Ce module de commande 18 ne comporte que des éléments passifs discrets, tels que des portes logiques ET ou OU et des résistances.

Le buffer 16 comporte, comme connu en soi, deux ensembles de bornes appariées deux à deux par voie permettant le transfert des données d'une borne d'un ensemble vers une autre borne appariée de l'autre ensemble suivant le sens de transfert sélectionné. Dans la suite, la borne recevant les données est désignée par entrée et la borne par laquelle ressortent les données du buffer est désignée par sortie.

Le buffer comporte par exemple huit voies, les bornes d'un ensemble étant notées de A1 à A8 et les bornes de l'autre ensemble étant désignées respectivement B1 à B8 pour les bornes appariées d'une même voie.

Dans l'exemple considéré, les bornes A3 à A8 sont reliées à des bornes correspondantes du processeur 12 et les bornes B3 à B8 sont reliées à des bornes correspondantes de la mémoire 14. Les bornes A1, A2, B1 et B2 sont réservées pour le module de commande 18, auquel elles sont reliées.

Comme connu en soi, le buffer 16 comporte une entrée de sens de transfert 20 dont le signal de sens appliqué est noté DIR et une entrée d'actionnement 22 dont le signal d'actionnement appliqué est noté OEn.

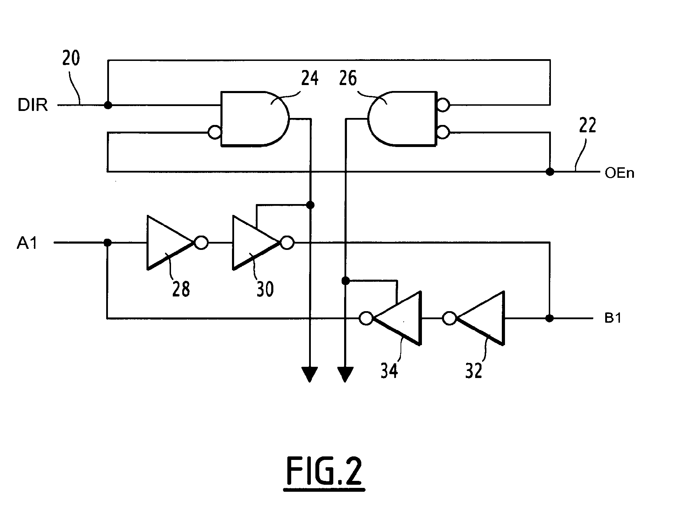

Sur la figure 2 est illustrée la structure interne du buffer 16. Sur cette figure, seules les bornes appariées A1 et B1 sont représentées, les autres bornes appariées A2-B2 à A8-B8 étant reliées par un agencement de même structure non représenté.

Sur cette figure, on retrouve l'entrée de sens 20 et l'entrée d'actionnement 22.

Le buffer 16 comporte deux portes ET 24, 26, dont les sorties sont propres à assurer la commande du sens de transfert de la borne A1 vers la borne B1 pour la porte 24 et de la borne B1 vers la borne A1 pour la porte 26.

La borne A1 est reliée à l'entrée d'un inverseur 28 dont la sortie est reliée à l'entrée d'un buffer à trois états dit « tri-state » 30 à sortie inverseuse dont la sortie est reliée à la borne B1 appariée.

La borne de commande du buffer tri-state 30 est reliée à la sortie de la porte ET 24. De même, la borne B1 est reliée à la borne A1 par successivement dans cet ordre un inverseur 32 et un buffer tri-state 34 dont la borne de commande est reliée à la sortie de la porte ET 26.

Il en est de même pour toutes les bornes appariées A2 à A8 avec les bornes B2 à B8.

L'entrée de sens 20 est reliée à l'une des entrées de la porte ET 24 et à une entrée inverseuse de la porte ET 26. De même, l'entrée d'activation 22 est reliée aux entrées des deux portes 24, 26 par deux entrées inverseuses.

Ainsi, pour chaque paire de bornes appariées, le buffer 16 est régi par la table de vérité suivante :

**Table de vérité 1**

| **Entrées de commande** | | **Bornes** | | **OPERATION** |
|---|---|---|---|---|
| OEn | DIR | A | B | |
| L | L | Enabled | Hi-Z | B vers A |
| L | H | Hi-Z | Enabled | A vers B |
| H | X | Hi-Z | Hi-Z | Isolation |

| | | | | |
|---|---|---|---|---|
| où : H = état haut ou 1 L = état bas ou 0 X = état quelconque Enabled = sortie active Hi-Z = état haute impédance | | | | |

Le circuit de transfert 18 comporte une entrée d'actionnement 40, une entrée de commande de sens de transfert 42 et une sortie 44 de lecture du sens de transfert.

L'entrée 40 est reliée à l'entrée d'actionnement 22, ainsi qu'à un potentiel de référence haut, noté V_{cc}, au travers d'une résistance 46.

L'entrée de commande de sens 42 est reliée à une première entrée d'une porte ET 50, elle-même reliée au potentiel de référence haut V_{cc} par une résistance 52. L'autre entrée de la porte 50 est reliée au potentiel de référence haut V_{cc} par une résistance 54 ainsi qu'à la borne A1 du buffer 16. La sortie de la porte 50 est reliée à l'entrée de sens 20 du buffer 16.

La borne B1 appariée à la borne A1 du buffer est reliée à la masse par une résistance 56.

La borne A2 est reliée directement à la sortie 44 de lecture du sens de transfert. Cette sortie est reliée également au potentiel de référence V_{cc} par une résistance 58.

La borne B2 appariée à la borne A2 est, pour sa part, reliée à la masse par une résistance 60.

Le fonctionnement du circuit d'échange de données bidirectionnel 10 va maintenant être décrit en regard de la figure 1 et en référence à la table de vérité 2 suivante :

**Table de vérité 2**

| OEn | DIR | F_DIR | A1 | B1 | Opération | Commentaire |
|---|---|---|---|---|---|---|
| 1 | X | X | Z₁ | Z₀ | isolation | La fonction F inhibe les ports de données A et B |
| 1 | 1 | 1 | Z₁ | Z₀ | isolation | Les IO de la fonction F sont en Z pendant son initialisation |
| 0 | 1 | 1 | Z₁ | 1 | A → B | La fonction F reçoit F_RD=1 (position écriture) |
| 0 | 0 | 0 | 0 | Z₀ | A ← B | La fonction F reçoit F_RD=0 (position lecture) |
| 0 | 0 | X | 0 | Z₀ | A ← B | Le buffer est positionné en lecture définitivement |

Sur cette table, figurent les valeurs des signaux OEn et DIR respectivement aux entrées de commande 22 et de sens 20 du buffer, ainsi que la valeur du signal F_{DIR} de commande de sens appliquée à l'entrée 42. Les signaux ou impédances constatés sur les bornes A1 et B1 du buffer sont également figurés. Les codes suivants sont utilisés :
- 0 / 1: : états logiques 0 / 1
- Z₀: : état Hi-Z (signal avec pull down)
- Z₁: : état Hi-Z (signal avec pull-up)
- X: : état quelconque
- IO: : entrée/sortie

Initialement, à la mise sous tension, le signal OEn est à l'état 1, garantissant ainsi que les buffers tri-state 30, 34 fournissent aux bornes A1 et B1 des états haute impédance, notés Z₁ et Z₀ respectivement, quelles que soient les valeurs des signaux DIR et F_{DIR}.

Le signal de sens de transfert F_{DIR} passant à 1, le signal de sens DIR passe également à 1, la porte ET 50, voyant un signal 1 à chacune de ses entrées.

Dans l'exemple considéré, quand DIR est égal à 1, le transfert des données s'effectue des bornes A vers les bornes B.

Au contraire, lorsque DIR est égal à 0, le transfert s'effectue des bornes B vers les bornes A.

Tant que le signal OEn n'est pas égal à 0, les bornes A et B sont isolées. Dès que le signal OEn passe à 0, le transfert des données des bornes A vers B est possible. Pendant cette phase, les données du processeur 12 sont transmises vers la mémoire 14 dans laquelle elles sont stockées.

Simultanément, la borne B1 passe à l'état 1, puisque la borne A1 est en haute impédance et produit un état logique haut égal à 1 du fait de sa connexion au potentiel de référence V_{cc} au travers de la résistance 54.

De même, la borne A2 passe à l'état 1, la borne A2 étant en haute impédance et reliée au potentiel de référence V_{cc} au travers de la résistance 58.

La sortie 44 fournit alors un signal F_RD égal à 1 qui est une information exploitable représentative du sens de transfert effectif du buffer.

Une fois l'ensemble des transferts des données réalisés des bornes A vers les bornes B, le signal F_{DIR} passe à 0 sous la commande d'une unité centrale de traitement d'informations adaptée, provoquant le passage à 0 du signal de sens DIR. Le sens de communication s'inverse alors, les bornes A recopiant les valeurs des bornes B.

La borne B1 étant reliée à la masse par la résistance 56, celle-ci est en haute impédance, assimilable à un état logique bas, conduisant à la création d'un état logique bas sur la borne A1. Cet état logique bas sur la borne A1 conduit à ce que l'une des entrées de la porte ET 50 soit égale à 0. Ainsi, quelle que soit la valeur du signal F_{DIR}, l'entrée de sens 20 reçoit un état logique bas produit par la porte ET 50, positionnant définitivement le sens de circulation des données des bornes B vers les bornes A.

De même, la borne B2 étant reliée à la masse par la résistance 60, celle-ci est en haute impédance assimilable à un état logique bas. La borne A2 fournit donc le signal F_RD égal à 0.

Le signal F_RD fournit alors à nouveau une information représentative du sens de transfert des données dans le buffer.

L'usage dans le buffer d'une voie séparée de la voie A1-B1 pour fournir l'information F_RD évite que le signal appliqué sur la borne A1 ne soit lu pour fournir le signal F_RD. En effet, en cas de dysfonctionnement des moyens de lecture connectés sur la borne A1, le signal sur cette borne pourrait être forcé à un état haut et donc repositionner le buffer dans le sens de transfert A vers B, ce qui doit être évité.

On conçoit qu'avec un tel circuit, on assure de manière fiable, du fait du recours à des composants discrets le blocage du transfert des données de la mémoire 14 vers le processeur 12, après une possibilité de transfert initial du processeur 12 vers la mémoire 14.

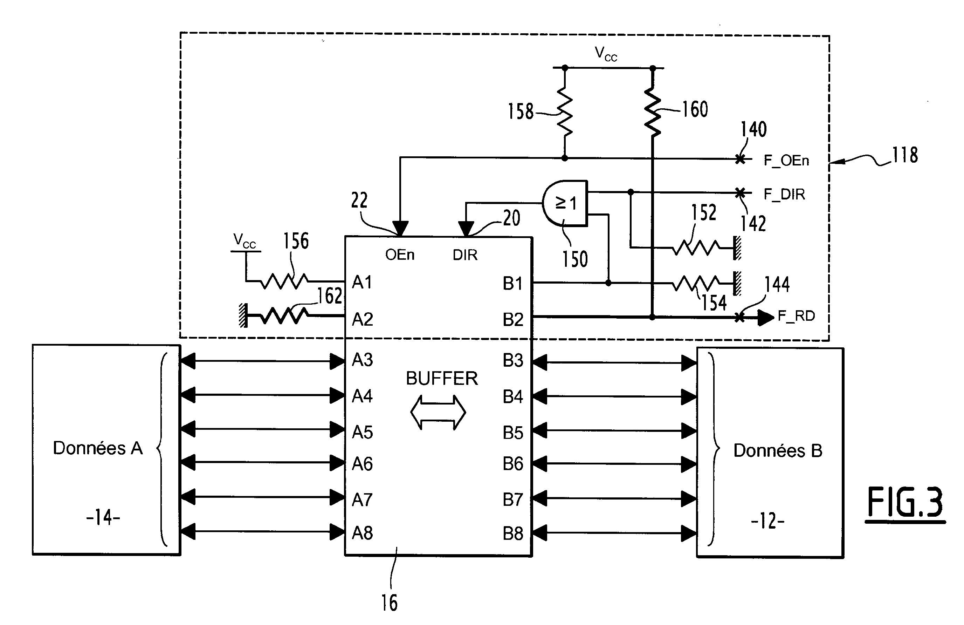

Sur la figure 3 est représentée une variante de réalisation du circuit mettant en oeuvre le même buffer 16 et permettant un blocage des transferts B vers A après une phase initiale de transfert possible. Dans ce cas, le processeur 12 est relié aux bornes B alors que la mémoire 14 est reliée aux bornes A.

Seules les différences par rapport au mode de réalisation précédent, sont décrites ici. Elles portent sur le module de commande noté 118.

Comme précédemment, le module de commande 118 comporte une entrée d'activation 140, une entrée de commande du sens 142 et une sortie 144 de lecture du sens de transfert.

L'entrée de commande de sens 142 est reliée à une première entrée d'une porte logique OU 150 dont la sortie est reliée à l'entrée de commande 20 du buffer 16. L'entrée 142 est en outre reliée à la masse par une résistance 152.

L'autre entrée de la porte OU 150 est reliée d'une part à la borne B1 du buffer 16 et d'autre part à la masse par une résistance 154.

La borne A1 appariée à la borne B1 du buffer est reliée à la tension de référence V_{cc} par une résistance 156. L'entrée d'actionnement 140 est reliée à l'entrée 22 ainsi qu'à la tension de référence V_{cc} par une résistance 158.

Enfin, la sortie de lecture du sens de transfert 144 est reliée à la borne B2 ainsi qu'au potentiel de référence au V_{cc} par une résistance 160, la borne appariée A2 à la borne B1 étant reliée à la masse par une résistance 162.

Le fonctionnement de ce second mode de réalisation de la figure 3 est décrit dans la suite en référence à la table de vérité 3.

**Table de vérité 3**

| OEn | DIR | F_DIR | B1 | A1 | Opération | Commentaire |
|---|---|---|---|---|---|---|
| 1 | X | X | Z₀ | Z₁ | isolation | La fonction F inhibe les ports de données A et B |
| 1 | 0 | 0 | Z₀ | Z₁ | isolation | Les IO de la fonction F sont en Z pendant son initialisation |
| 0 | 0 | 0 | Z₀ | 0 | B → A | La fonction F reçoit F_RD=1 (position écriture) |
| 0 | 1 | 1 | 1 | Z₁ | B ← A | La fonction F reçoit F_RD=0 (position lecture) |
| 0 | 1 | X | 1 | Z₁ | B ← A | Le buffer est positionné en lecture définitivement |

Ces notations sont les mêmes que dans la table 2.

Comme précédemment, lors de la mise sous tension, le signal OEn est à l'état 1 de sorte que les bornes B1 et A1 fournissent des états haute impédance respectivement Z₀ et Z₁. Lorsque le signal de sens de transfert F_{DIR} passe à 0, le signal de sens DIR passe également à 0, puisque, la borne B1 reliée à la masse par la résistance 154 produit un état logique bas.

Le transfert s'effectue donc dans le buffer 16 des bornes B vers les bornes A potentiellement.

Lorsque le signal OEn passe à 0, le transfert des données des bornes B vers A est possible. Les données du processeur 12 sont alors transmises vers la mémoire 14.

La borne A1 passe à l'état 0, puisque la borne B1 qu'elle recopie est en haute impédance et produit un état logique bas égal à 0 du fait de la connexion à la masse au travers de la résistance 154.

La borne B2 est à l'état 1, du fait de sa connexion au potentiel de référence Vcc par la résistance 160. La sortie 144 fournit alors un signal F_RD égal à 1 caractérisant un sens de transfert du processeur 12 vers la mémoire 14.

Après réalisation des transferts, le signal F_{DIR} passe à 1 sous la commande d'unité centrale de traitement d'informations de sorte que le signal de sens DIR passe également à 1. Le transfert des données n'est alors possible que de la mémoire 14 vers le processeur 12.

La borne A1 étant reliée à la tension de référence V_{cc} par la résistance 156, elle est maintenue en permanence à un état haute impédance égal à Z₁ puisque A1 n'est plus une sortie mais une entrée haute impédance. Cela garantit que l'entrée de la porte OU 150 reliée à la borne B1 reçoive en permanence un état logique haut.

Ainsi, de la sorte quelle que soit la valeur du signal F_{DIR}, l'entrée de sens 20 reçoit un état logique haut, bloquant ainsi le transfert des données de la mémoire 14 vers le processeur 12.

Cet agencement procure les mêmes avantages que celui décrit en regard de la figure 1.

## Revendications

1. Circuit d'échange (10) de données bidirectionnel comportant :
- un buffer (16) comportant :
- un premier ensemble de bornes (A1... A8) et un second ensemble de bornes (B1... B8) dont les bornes sont appariées deux à deux pour un échange de données bidirectionnel entre deux bornes appariées des deux ensembles ;
- une entrée (20) de sens de transfert entre deux bornes appariées d'une entrée vers une sortie, l'entrée étant placée en haute impédance en l'absence de tension à ces bornes ;
- une entrée (42 ; 142) de commande du sens de transfert ;
**caractérisé en ce qu'**il comporte :
- une porte logique (50 ; 150) dont :
- la sortie est reliée à l'entrée (20) de sens de transfert du buffer (16) ;
- une entrée est reliée à l'entrée de commande du sens de transfert (42 ; 142), cette entrée étant en outre reliée à un premier potentiel de référence (V_{cc} ; 0) par une résistance (52 ; 152) ; et
- l'autre entrée est reliée à une borne (A1 ; B1) du buffer (16) et au premier potentiel de référence (V_{cc} ; 0) par une résistance (54 ; 154) ;
- la borne (B1 ; A1) du buffer (16) appariée à la borne (A1 ; B1) du buffer à laquelle est reliée l'autre entrée de la porte logique (50 ; 150) étant reliée à un second potentiel de référence (0 ; V_{cc}) par une résistance (56 ; 156) ;
et **en ce que** les premier et second potentiels de référence et la nature de la porte logique (50 ; 150) sont tels que, après une première commande de sens de transfert du buffer dans un sens, les deux bornes appariées (A1 ; B1) réservées pour le module de commande forcent la porte logique (50 ; 150) dans un état prédéterminé indépendant de la valeur du signal sur l'entrée de commande de sens (42 ; 142).

2. Circuit d'échange (10) selon la revendication 1, **caractérisé en ce que** la porte logique est une porte ET (50), et le second potentiel de référence est inférieur au premier potentiel de référence.

3. Circuit d'échange (10) selon la revendication 1, **caractérisé en ce que** la porte logique est une porte OU (150) et le second potentiel de référence est supérieur au premier potentiel de référence.

4. Circuit logique selon l'une quelconque des revendications précédentes, **caractérisé en ce que** le buffer (16) comporte une entrée (22) pour un signal d'activation, interdisant tout transfert entre deux bornes appariées en l'absence de signal d'activation.

5. Circuit logique selon l'une quelconque des revendications précédentes, **caractérisé en ce que** le buffer (16) comporte deux bornes auxiliaires appariées (A2, B2) différentes des bornes appariées (A1, B1) en relation avec l'entrée (20) de commande de direction, dont :
- la borne (A2 ; B2) auxiliaire du même ensemble que la borne (A1 ; B1) reliée à la porte logique (50 ; 150) est reliée :
- d'une part, à une sortie (44 ; 144) de fourniture d'une information représentative du sens de transfert et,
- d'autre part, par une résistance (58 ; 160), à un des premier et second potentiels de référence (V_{cc} ; 0), et
- l'autre borne auxiliaire (B2 ; A2) est reliée par une résistance (60 ; 162) à l'autre des premier et second potentiels de référence (V_{cc} ; 0).

## Patentansprüche

1. Schaltung (10) zum bidirektionalen Austauschen von Daten aufweisend:
- einen Puffer (16) aufweisend:
- eine erste Menge von Anschlüssen (A1 ... A8) und eine zweite Menge von Anschlüssen (B1 ... B8), deren Anschlüsse zwei zu zwei gepaart sind zum bidirektionalen Austauschen von Daten zwischen zwei gepaarten Anschlüssen von zwei Mengen;
- einen Eingang (20) der Richtung der Übertragung zwischen zwei gepaarten Anschlüssen von einem Eingang zu einem Ausgang, wobei der Eingang hochohmig gesetzt ist bei Fehlen von Spannung an diesen Anschlüssen;
- einen Eingang (42; 142) zum Steuern der Übertragungsrichtung;
dadurch charakterisiert, dass sie aufweist:
- ein Logik-Gatter (50; 150), bei dem:
- der Ausgang mit dem Eingang (20) der Richtung der Übertragung des Puffers (16) verbunden ist;
- ein Eingang mit dem Steuereingang der Richtung der Übertragung (42; 142) verbunden ist, wobei dieser Eingang außerdem durch einen Widerstand (52; 152) mit einem ersten Referenzpotential (V_{cc}; 0) verbunden ist; und
- der andere Eingang mit einem Anschluss (A1; B1) des Puffers (16) und durch einen Widerstand (54; 154) mit dem ersten Referenzpotential (V_{cc}; 0) verbunden ist; und
- der Anschluss (B1; A1) des Puffers (16), der mit dem Anschluss (A1; B1) des Puffers gepaart ist, mit dem der andere Eingang des Logik-Gatters (50; 150) verbunden ist, durch einen Widerstand (56; 156) mit einem zweiten Referenzpotential verbunden ist;
und dadurch, dass das erste Referenzpotential und das zweite Referenzpotential und die Beschaffenheit des Logik-Gatters (50; 150) derart sind, dass, nach einem ersten Befehl der Richtung der Übertragung des Puffers in eine Richtung die zwei gepaarten Anschlüsse (A1, B1), die für das Steuermodul reserviert sind, das Logik-Gatter (50; 150) unabhängig von dem Wert des Signals an dem Eingang zum Steuern der Übertragungsrichtung (42; 142) in einen vorgegebenen Zustand zwingen.

2. Schaltung zum Austauschen (10) gemäß dem Anspruch 1, dadurch charakterisiert, dass das Logik-Gatter ein UND-Gatter (50) ist und das zweite Referenzpotential niedriger ist als das erste Referenzpotential.

3. Schaltung zum Austauschen (10) gemäß dem Anspruch 1, dadurch charakterisiert, dass das Logik-Gatter ein ODER-Gatter (150) ist und das zweite Referenzpotential höher ist als das erste Referenzpotential.

4. Logik-Schaltung gemäß einem der vorhergehenden Ansprüche, dadurch charakterisiert, dass der Puffer (16) einen Eingang (22) für ein Aktivierungssignal aufweist, der jede Übertragung zwischen zwei gepaarten Anschlüssen bei Fehlen des Aktivierungssignals verbietet.

5. Logik-Schaltung gemäß einem der vorhergehenden Ansprüche, dadurch charakterisiert, dass der Puffer (16) zwei gepaarte Hilfsanschlüsse (A2, B2) aufweist, die von den gepaarten Anschlüssen (A1, B1) unterschiedlich sind, verbunden mit dem Eingang (20) zum Steuern der Richtung, von denen:
- der Hilfsanschluss (A2; B2) aus derselben Menge wie der Anschluss (A1; B1), der mit dem Logik-Gatter (50; 150) verbunden ist, verbunden ist:
- einerseits mit einem Ausgang (44; 144) zum Bereitstellen einer Information repräsentativ für die Richtung der Übertragung und
- andererseits, durch einen Widerstand (58; 160), mit einem von dem ersten Referenzpotential und dem zweiten Referenzpotential (Vcc; 0) und
- der andere Hilfsanschluss (B2; A2) durch einen Widerstand (60; 162) mit dem anderen von dem ersten Referenzpotential und dem zweiten Referenzpotential (Vcc; 0) verbunden ist.

## Claims

1. A bidirectional data exchange circuit (10) including:
- a buffer (16) including:
- a first set of terminals (A1... A8) and a second set of terminals (B1... B8) the terminals of which are matched pairwise for a bidirectional data exchange between two matched terminals of both sets;
- a transfer direction input (20) between two matched terminals from an input to an output, the input being placed at a high impedance state in the absence of voltage on these terminals;
- an input (42; 142) for controlling the transfer direction;
**characterized in that** it includes:
- a logic gate (50; 150) for which:
- the output is connected to the transfer direction input (20) of the buffer (16);
- an input is connected to the input for controlling the transfer direction (42; 142), this input being further connected to a first reference potential (V_{cc;} 0) through a resistor (52; 152); and
- the other input is connected to a terminal (A1; B1) of the buffer (16) and to the first reference potential (V_{cc}; 0) through a resistor (54; 154);
- the terminal (B1; A1) of the buffer (16) matched with the terminal (A1; B1) of the buffer to which is connected the other input of the logic gate (50; 150) being connected to a second reference potential (0; V_{cc}) through a resistor (56; 156);
and **in that** the first and second reference potentials and the nature of the logic gate (50; 150) are such that, after a first transfer direction control of the buffer in one direction, the two matched terminals (A1; B1) reserved for the control module force the logic gate (50; 150) into a predetermined state independent of the value of the signal on the direction control input (42; 142).

2. The exchange circuit (10) according to claim 1, **characterized in that** the logic gates is an AND gate (50), and the second reference potential is lower than the first reference potential.

3. The exchange circuit (10) according to claim 1, **characterized in that** the logic gate is an OR gate (150) and the second reference potential is higher than the first reference potential.

4. The logic circuit according to any of the preceding claims, **characterized in that** the buffer (16) includes an input (22) for an activation signal, preventing any transfer between two matched terminals in the absence of an activation signal.

5. The logic circuit according to any of the preceding claims, **characterized in that** the buffer (16) includes two matched auxiliary terminals (A2, B2) different from the matched terminals (A1, B1) in connection with the direction control input (20), for which:
- the auxiliary terminal (A2; B2) of the same set as the terminal (A1; B1) connected to the logic gate (50; 150) is connected:
- to an output (44; 144) for providing a piece of information representative of the transfer direction on the one hand and,
- through a resistor (58; 160), to one of the first and second reference potentials (V_{cc}; 0) on the other hand, and
- the other auxiliary terminal (B2; A2) is connected through a resistor (60; 162) to the other one of the first and second reference potentials (V_{cc}; 0).
